# EUROPÄISCHE PATENTSCHRIFT

(11) **EP 1 870 487 B1**
(45) Veröffentlichungstag und Bekanntmachung des Hinweises auf die Patenterteilung: **29.07.2009**
(21) Anmeldenummer: 06012805.5
(22) Anmeldetag: 22.06.2006
(51) Int. Cl.: C23C 14/56

(54) **Vakuumbeschichtungsanlage**
Vaccum coating apparatus
Appareillage de revêtement sous vide

(43) Veröffentlichungstag der Anmeldung: 26.12.2007
(73) Patentinhaber: Applied Materials GmbH & Co. KG, 63755 Alzenau (DE)
(72) Erfinder: Henrich, Jürgen, 63694 Limeshain (DE); Sauer, Andreas, 63762 Großostheim (DE); Wurster, Harald, 63776 Mömbris (DE); Haberkorn, Edgar, 63637 Jossgrund (DE)
(74) Vertreter: Schickedanz, Willi

(56) Entgegenhaltungen:
- GB-A- 2 171 119
- JP-A- 2003 341 835
- US-A- 4 693 803

## Beschreibung

Die Erfindung betrifft eine Vakuumbeschichtungsanlage nach den Oberbegriffen der Patentansprüche 1 oder 2.

In Vakuumbeschichtungsanlagen erfolgt die Beschichtung eines Substrats dadurch, dass aus einem Target Teilchen herausgeschlagen werden, die sich in Richtung des Substrats bewegen und sich dort niederschlagen. Um eine gleichmäßige Beschichtung des Substrats zu erhalten, führen Substrat und Target eine Relativbewegung zueinander durch, wobei vorzugsweise das Substrat am Target vorbeibewegt wird.

Das Substrat wird dabei mittels einer besonderen Transportvorrichtung bewegt.

Soll ein großflächiges und im Wesentlichen starres Substrat beschichtet werden, z. B. Architekturglas, so bedient man sich häufig eines Transportsystems, das aus verschiedenen hintereinander angeordneten Transportrollen besteht. Diese Transportrollen sind über Zahnriemen, Ketten oder Zahnräder miteinander verbunden und werden mittels eines gemeinsamen Antriebs, z. B. mittels eines Motors, angetrieben.

Es ist bereits eine Antriebsvorrichtung für eine Welle bekannt, die sich in einer Kammer befindet (US 2005/0206260 A1). Diese Welle wird hierbei über eine Magnetkupplung mittels eines Motors betrieben, wobei sich der Motor außerhalb der Kammer befindet.

Außerdem ist eine Transportvorrichtung für Substrate in Vakuumbeschichtungsanlagen mit mehreren Rollen bekannt, wobei mindestens eine Rolle als Antriebswelle dient (DE 103 28 273 A1). In dieser Vorrichtung befinden sich der Antrieb sowie die Transportrollen allesamt im evakuierten Bereich der Beschichtungsanlage.

Schließlich ist auch noch eine Prozesskammer bekannt, die ein Transportsystem für Werkstücke aufweist (GB 2 171 119 A). Dieses Transportsystem enthält Walzen, die durch eine Magnetkupplung angetrieben werden. Hierbei dient die Magnetkupplung nicht zur Drehmomentübertragung von außen in die Prozesskammer, sondern zum Umschalten zwischen zwei auf einem Lift angebrachten Sätzen von Transportrollen innerhalb der Kammer.

Die Aufgabe der vorliegenden Erfindung besteht darin, eine Transportvorrichtung für ein flächiges Substrat in Vakuumbeschichtungsanlagen bereitzustellen, wobei der Ein- und Ausbau dieser Transportvorrichtung in die Vakuumbeschichtungsanlage ohne große Schwierigkeiten zu bewerkstelligen ist.

Diese Aufgabe wird gemäß den Merkmalen der Patentansprüche 1 oder 2 gelöst.

Die Erfindung betrifft somit eine Vakuumbeschichtungsanlage mit einem Transportsystem für flächige Substrate, die durch eine Vakuumkammer transportiert werden. Dieses Transportsystem weist mehrere parallel zueinander angeordnete Walzen auf. Als Antrieb für diese Walzen können ein oder mehrere Motoren vorgesehen werden, die sich innerhalb oder außerhalb der Vakuumkammer befinden. In jedem Fall erfolgt die Kopplung zwischen dem Motor bzw. den Motoren und den Walzen über Magnetkupplungen. Da hierdurch keine mechanische Kopplung zwischen dem Antrieb und den Walzen gegeben ist, können diese leicht voneinander getrennt werden, was es ermöglicht, die Walzen und mit ihnen die Sputterkathoden in einem Einschubelement vorzusehen, das in die Vakuumkammer eingefahren und aus dieser herausgefahren werden kann. Wird nicht jede Walze mit einem eigenen Antrieb versehen, können die Walzen, die mit einem Antrieb gekoppelt sind, über Keilriemen oder dergleichen mit den anderen Walzen verbunden werden.

Der mit der Erfindung erzielte Vorteil besteht insbesondere darin, dass keine sich drehenden Dichtelemente, beispielsweise Wellendichtringe oder Fluiddichtungen benötigt werden. Außerdem werden potentielle Leckstellen vermieden. Magnetkupplungen sind überdies kontaktlos und damit verschleiß- und wartungsfrei; sie können auch kostengünstiger als Drehdurchführungen hergestellt werden. Hinzu kommt, dass bei Magnetkupplungen über den Magnetabstand auf einfache Art eine Drehmomentbegrenzung eingestellt werden kann.

Handelt es sich um eine mit Transportrollen versehene Transportvorrichtung für den Transport von großflächigen Substraten, wie z. B. Folien oder Glas, insbesondere Architekturglas, so ist es besonders vorteilhaft, wenn jede der Transportrollen über eine eigene Magnetspaltkupplung verfügt. Gegenüber den drehstabilen Kupplungen besitzen die Magnetspaltkupplungen insbesondere den Vorteil, dass sie vakuumdicht sind. Diese Eigenschaft macht sie geradezu ideal für den Einsatz in Vakuumbeschichtungsanlagen. Von Vorteil ist auch, dass die Magnetspaltkupplungen in radialer und in axialer Bauart ausgeführt sein können.

So kann die Antriebsmechanik nicht nur wie in herkömmlicher Weise im Vakuum, sondern auch an der Atmosphäre liegen.

Dadurch, dass die Antriebsmechanik an der Atmosphäre liegt, sind Wartungen und Reparaturen weniger aufwändig, da die langen Evakuierungszeiten von mehreren Stunden entfallen, wodurch die Produktionskosten stark reduziert werden. Ist die Antriebsmechanik an der Atmosphäre untergebracht, bedeutet das zudem, dass die relativ teuren Vakuumdrehdurchführungen nicht mehr benötigt werden. Sie sind durch die sehr viel preiswerteren Magnetspaltkupplungen ersetzt. Durch den Einsatz der Magnetspaltkupplungen sind deshalb keine drehbaren Dichtelemente, wie z. B. Wellen- oder Fluiddichtungen, mehr einzubauen, wodurch potentielle Leckstellen vermieden werden.

Da der Antrieb, z. B. ein Elektromotor, die Drehbewegung über die Magnetspaltkupplung auf die Transportrollen überträgt, kann auch die Transportgeschwindigkeit des Substrats einfach eingestellt werden. Zum einen kann die Transportgeschwindigkeit über den Antrieb selbst eingestellt werden. Zum andern erhält man über den Abstand der Magnete zueinander eine Drehmomentbegrenzung, wobei auch die Stärke der Magnete einen entscheidenden Einfluss auf das Drehmoment hat.

Die Transportrollen müssen zur regelmäßigen Reinigung entnommen werden, was bei den erfindungsgemäßen Transportrollen leicht zu realisieren ist, denn die Verbindung zwischen dem auszubauenden Teil und dem Antrieb kann leicht gelöst werden, d. h. der Ausbau der Transportrollen ist ohne größeren Aufwand zu bewerkstelligen. Auch der Wiedereinbau lässt sich leicht realisieren, ganz im Gegensatz zu den Beschichtungsvorrichtungen mit Drehdurchführungen.

Ein Ausführungsbeispiel der Erfindung ist in den Zeichnungen dargestellt und wird nachfolgend näher erläutert. Es zeigen:
Fig. 1 eine perspektivische Darstellung eines Ausschnitts einer Vakuumbeschichtungsanlage mit einer Transportvorrichtung;
Fig. 2 eine Ansicht A auf die Vakuumbeschichtungsanlage gemäß Fig. 1;
Fig. 3 einen vergrößerten Teilausschnitt der in Fig. 2 dargestellten Vakuumbeschichtungsanlage;
Fig. 4 a - c den Vorgang des Herausnehmens eines Einschubelements der in Fig. 2 dargestellten Vakuumbeschichtungsanlage;
Fig. 5 einen Ausschnitt der in den Fig. 4a bis 4c dargestellten Vakuumbeschichtungsanlage nach Drehung dieser um 90° entgegen dem Uhrzeigersinn;
Fig. 6 eine perspektivische Ansicht eines Einschubelements;
Fig. 7 eine perspektivische Ansicht des in Fig. 5 dargestellten Einschubelements nach dessen Drehung um 180°.

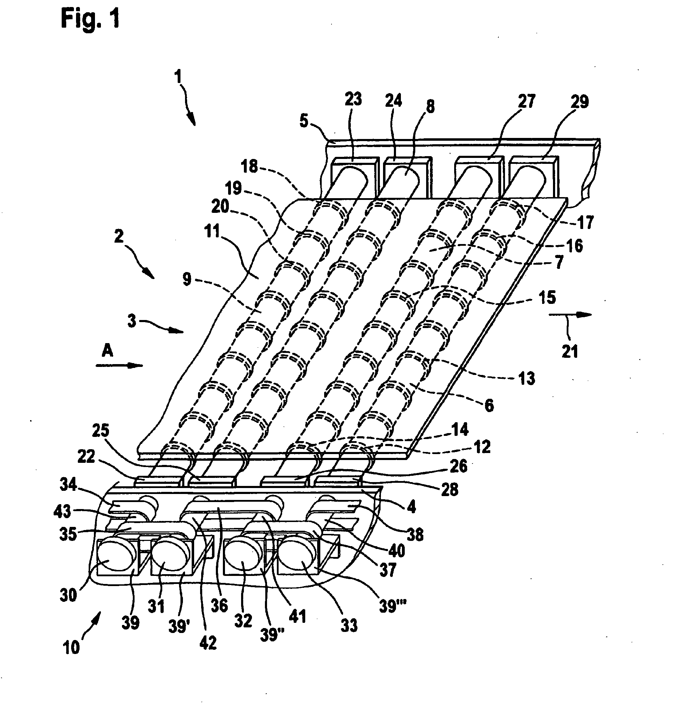

Fig. 1 zeigt eine perspektivische Ansicht eines Ausschnitts aus einer Vakuumbeschichtungskammer 2 in einer Vakuumbeschichtungsanlage 1. Zu erkennen sind Teilbereiche von zwei gegenüberliegenden und die Vakuumbeschichtungskammer 2 abgrenzenden Wänden 4, 5. In der Vakuumbeschichtungskammer 2 ist eine Transportvorrichtung 3 angeordnet, die mehrere parallel zueinander verlaufende Transportrollen 6, 7, 8, 9 aufweist. Diese Transportrollen 6 bis 9 werden über ein außerhalb der Vakuumbeschichtungskammer 2 sitzendes Antriebssystem 10 angetrieben. Mit Hilfe dieses Antriebssystems 10 führen die Transportrollen 6 bis 9 eine Drehbewegung um die eigene Längsachse aus. Auf den Transportrollen 6 bis 9 liegt ein Substrat 11, welches beschichtet werden soll. Es handelt sich hierbei um ein flächiges Substrat, z. B. Architekturglas. Damit das Substrat 11 nicht direkt auf den Transportrollen 6 bis 9 aufliegt, kann auf den Außenseiten der Transportrollen 6 bis 9 z. B. gummielastisches Material angebracht sein. Dieses dient dazu, dass das Substrat 11 nicht verkratzt wird, was gerade dann wichtig ist, wenn es sich bei dem Substrat um Glas handelt.

Das gummielastische Material kann, wie in Fig. 1 dargestellt, in Form von Ringen 12 bis 20 an den Transportrollen 6 bis 9 angeordnet sein. Es kann aber auch eine beliebige andere Form annehmen und zum Beispiel in Form von Noppen ausgestaltet sein. Durch die Bewegung der Transportrollen 6 bis 9 wird das auf ihnen angeordnete Substrat 11 ebenfalls bewegt.

Eine jede Transportrolle 6 bis 9 ist zwischen zwei Lagern 22, 23; 24, 25; 26, 27; 28, 29 angeordnet, die eine Drehung der Transportrollen 6 bis 9 um die eigene Achse gewährleisten. Es sind aber auch einseitig eingespannte Transportrollen realisierbar.

Die Transportrollen 6 bis 9 stehen mit dem Antriebssystem 10 in Verbindung, das über mehrere Einzelantriebe, z. B. Motoren 30 bis 33, verfügen kann. Diese Motoren 30 bis 33 sind mit den Enden von Achsen 40 bis 43 gekoppelt. Mit Hilfe der Motoren 30 bis 33 können die Transportrollen 6 bis 9 über die Achse 40 und in der Fig. 1 nicht erkennbare Magnetkupplungen einzeln angetrieben werden.

In dem Ausführungsbeispiel gemäß Fig. 1 würde allerdings ein einziger Motor, z. B. 30, für den Antrieb aller Transportrollen 6 bis 9 genügen, weil die Achse 43 auch die Achse 42 über einen Zahnriemen 35 antreibt und die Achse 42 ihrerseits über einen Zahnriemen 36 die Achse 41 antreibt etc. Da alle Achsen 40 bis 43 über Zahnriemen 34 bis 38 mit der jeweils benachbarten Achse gekoppelt sind, genügt somit nur ein Motor.

Wird auf die Zahnriemen 34 bis 38 verzichtet, so kann jede Achse 40 bis 43 über ihren eigenen Motor 30 bis 33 angetrieben werden.

Die Achsen 40 bis 43 ruhen auf Stützen 39 bis 39"', die mit der Wand 4 in Verbindung stehen.

Unabhängig davon, ob ein Motor oder mehrere Motoren verwendet werden, wird eine gleichmäßige Drehung aller Transportrollen 6 bis 9 angestrebt.

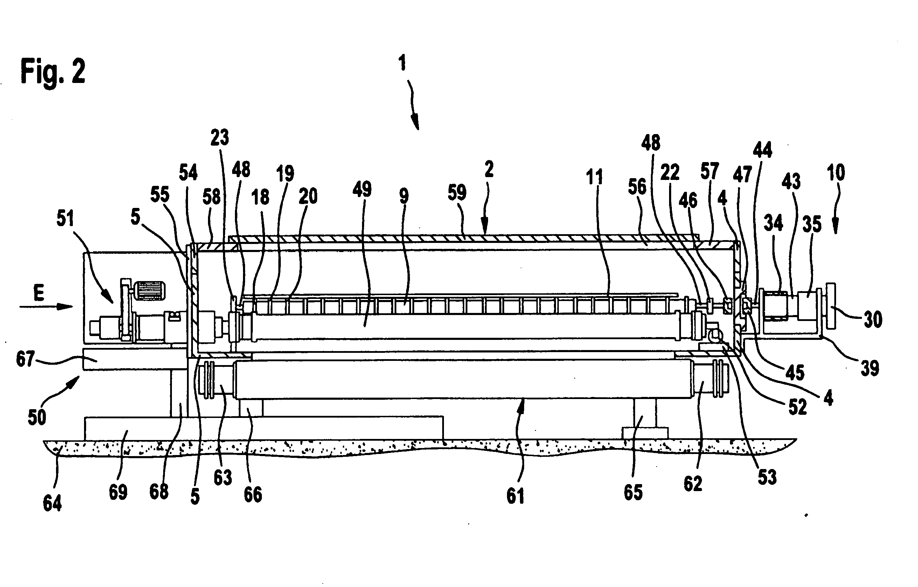

Die in der Fig. 1 nicht erkennbaren Magnetkupplungen befinden sich im Wesentlichen in der Wand 4. Eine dieser Magnetkupplungen ist in der Fig. 2 dargestellt.

In Fig. 2 ist eine Ansicht A auf die Vakuumbeschichtungsanlage 1 gemäß Fig. 1 gezeigt. Diese Schnittansicht zeigt einen Teil des Antriebssystems 10 mit dem Motor 30 und der Achse 43, auf der die Ketten oder die Riemen 34, 35 angeordnet sind. Die Achse 43, an deren Ende der Motor 30 angeflanscht ist, liegt auf der Stütze 39 auf. Die Stütze 39 ist mit der Wand 4 der Vakuumbeschichtungskammer 2 verbunden und dient zum Stabilisieren und Abstützen von Achse 43 und Motor 30. Die mit dem Motor 30 verbundene Achse 43 weist eine stabförmige Verlängerung 44 auf, an deren Ende ein Magnet 45 angeordnet ist.

Dieser Magnet 45 liegt einem weiteren Magneten 46 gegenüber, der sich in der Vakuumbeschichtungskammer 2 befindet. Beide Magnete 45, 46 sind durch einen topfähnlichen Aufbau 47 getrennt, wobei der topfähnliche Aufbau 47 einen Teil der Wand 4 der Vakuumbeschichtungskammer 2 bildet. Dieser Aufbau 47 besteht aus einem nicht magnetisierbaren bzw. nicht magnetischen Material, wodurch gewährleistet wird, dass sich die Magnete 45, 46 gegenseitig magnetisch beeinflussen können.

Der Magnet 46 ist an einem Ende einer stabförmigen Achse 48 angeordnet, die mit der Transportrolle 9 verbunden ist. Die Achse 48 mit der daran angeordneten Transportrolle 9 ist zwischen den zwei gegenüberliegenden Lagern 22, 23 angebracht, die die Transportrolle 9 halten. Die Transportrolle 9 verfügt über mehrere vorzugsweise aus gummielastischem Material bestehende Ringe 18 bis 20, auf denen das Substrat 11 aufliegt.

Zu erkennen ist auch eine rohrförmige Kathode 49, die etwas unterhalb der Transportrolle 9 angeordnet ist. Dabei liegt die Kathode zwischen zwei benachbarten Transportrollen, sodass das Substrat 11 von unten her beschichtet wird. Es ist aber auch möglich, durch Anbringen von Kathoden oberhalb des Substrats 11, dieses von oben her zu beschichten.

Wie in Fig. 2 dargestellt, handelt es sich bei dieser Kathode um eine Rundrohrkathode 49, die mit einer außerhalb der Vakuumbeschichtungskammer 2 liegenden Antriebskammer 50 in Verbindung steht. In dieser Antriebskammer 50 befindet sich ein Antrieb 51, über den die Rundrohrkathode 49 angetrieben wird. Dabei rotiert sie um die Längsachse, wodurch eine gleichmäßige Beschichtung des Substrats 11 erreicht wird.

Bei dieser Rundrohrkathode 49 handelt es sich um eine herkömmliche Rundrohrkathode mit einem auf ihr angebrachten Target, wie es z. B. in DE 196 51 378 A1 beschrieben ist.

Während die Rundrohrkathode 49 an ihrem einen Ende mit dem in der Antriebskammer 50 befindlichen Antrieb 51 verbunden ist, ruht sie mit ihrem anderen Ende auf einer Rolle 52. Diese drehbare Rolle 52 ruht ihrerseits auf einer Auflageschiene 53.

Die Rolle oder Walze 52 befindet sich im eingebauten Zustand des Einschubelements E nahe an der Wand 4. Eine weitere, nicht dargestellte Rolle oder Walze des Einschubelements E befindet sich in der Nähe der Wand 5, wenn das Einschubelement in die Vakuumkammer eingebaut ist. Die Auflageschiene 53 erstreckt sich, anders als in Fig. 2 dargestellt, vorzugsweise über die gesamte Breite der Vakuumkammer. Nahe der Wand 5 ist diese Auflageschiene 53 mit einem Anschlag versehen. Das Trägerelement 69 des Einschubelements E erstreckt sich im Wesentlichen über die gesamte Breite der Vakuumkammer 2. Es umschließt auch den Fuß 65.

Auf der Seite des Antriebssystems 10 für die Transportrollen 6 bis 9 weist die Vakuumbeschichtungskammer 2 die Wand 4 mit dem in ihr eingelassenen topfähnlichen Aufbau 47 auf. Die der Wand 4 gegenüberliegende Seite weist eine Wand aus zwei Wandbereichen auf, einen unteren Wandbereich 5 und einen oberen Teil Wandbereich 54. Diese beiden Wandbereiche 5, 54 können voneinander getrennt werden und sind, wenn die Vakuumbeschichtungsanlage 1 in Betrieb ist, über einen Flansch 55 miteinander verbunden. Die Vakuumbeschichtungskammer 2 besitzt eine obere Öffnung 56, die von zwei an den Wänden 4 und 54 angebrachten Flanschen 57, 58 umgeben und mittels eines Deckels 59 verschlossen ist.

Die Vakuumbeschichtungsanlage 1 weist außerdem ein Pumpensystem 61 auf, das zwei Pumpen 62, 63 enthält.

Mittels dieses Pumpensystems 61 kann die Vakuumbeschichtungskammer 2 evakuiert werden. Die Vakuumbeschichtungskammer 2 sowie das Pumpensystem 61 ruhen auf mehreren Sockeln auf einer ebenen Fläche 64. Von diesen Sockeln sind in Fig. 2 nur die Sockel 65 und 66 zu sehen.

Die Antriebskammer 50 ist auf einem Gestell 67, 68 angeordnet, welches auf dem Trägerelement 69 ruht.

Das Gestell 67, 68, das Trägerelement 69 sowie die Antriebskammer 50 bilden dabei eine Einheit. Direkt mit der Antriebskammer 50 verbunden sind die Wand 5 sowie die Rundrohrkathode 49 und die Transportrolle 9. Zusammen bilden sie das Einschubelement E. Dieses Einschubelement E kann von der Vakuumbeschichtungsanlage 1 entfernt werden, ohne dass die gesamte Vakuumbeschichtungskammer 2 auseinander genommen werden muss (vgl. europäische Patentanmeldung 05 021 176.2).

Dadurch können die Transportrollen 6 bis 9 bequem gereinigt werden, wodurch Zeit und Geld eingespart werden können. Während der Reinigung kann ein anderes Einschubelement in die Vakuumbeschichtungskammer 2 eingeschoben und montiert werden. Die Vakuumbeschichtungsanlage 1 kann somit schnell wieder in Betrieb genommen werden, womit Kosten eingespart werden können.

Obwohl die Vakuumbeschichtungskammer gemäß Fig. 2 nur mit einer Rundrohrkathode 49 beschrieben wurde, ist natürlich auch der Einsatz von planaren Targets möglich. So kann beispielsweise ein planares Target oberhalb des Substrats 11 angeordnet sein, wobei das Substrat 11 in der beschriebenen Art und Weise am Target vorbeibewegt wird.

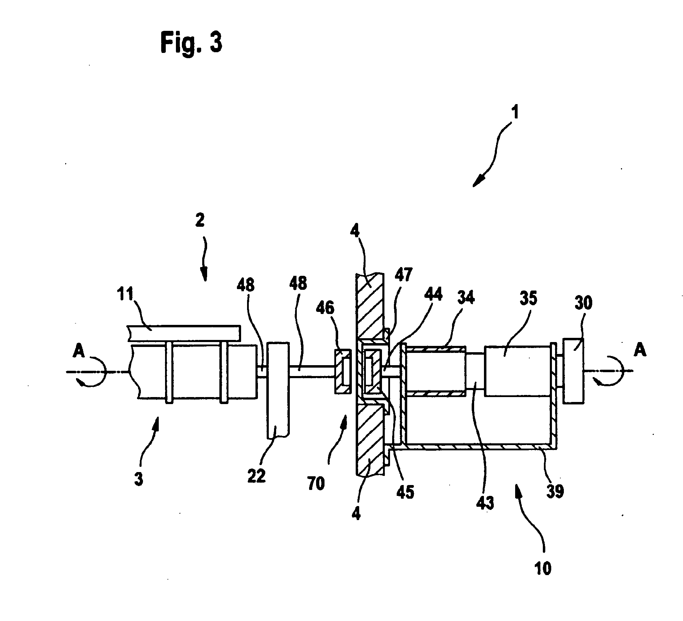

Fig. 3 zeigt einen vergrößerten Teilausschnitt der rechten Seite der in Fig. 2 dargestellten Vakuumbeschichtungsanlage 1. Man erkennt einen Teil des Antriebssystems 10 mit der auf der Stütze 39 angebrachten Achse 43, an deren Ende der Motor 30 zu erkennen ist.

In Richtung zur Wand 4 der Vakuumbeschichtungskammer 2 weist die Achse 43 eine stabförmige Verlängerung 44 auf, an deren Ende sich der Magnet 45 befindet, der einen Nord- und einen Südpol aufweist. Gegenüber diesem Magneten 45 befindet sich ein weiterer gleich aufgebauter Magnet 46. Zwischen den beiden Magneten 45, 46 ist ein topfförmiger Aufbau 47 vorgesehen. Die Magnete 45, 46 und der topfartige Aufbau 47 bilden zusammen eine so genannte Magnetspaltkupplung 70. Dabei besteht der topfartige Aufbau 47 aus einem Material, das nicht magnetisierbar und nicht magnetisch ist, wobei dieser Aufbau 47 vakuumdicht in die Wand 4 eingelassen ist.

Wird die Achse 43 des Antriebssystems 10 über den Motor 30 bewegt, so führt die Achse 43 eine Bewegung um A-A herum aus. Damit wird auch der an der stabförmigen Verlängerung 44 der Achse 43 befindliche Magnet 45 in eine Drehbewegung versetzt.

Da der Aufbau 47 aus einem nicht magnetisierbaren Material, z. B. aus Aluminium oder Quarz besteht, wird die Drehbewegung des Magnets 45 auf den Magnet 46 übertragen. Da dieser Magnet 46 über eine Achse 48 mit der Transportrolle 9 in Verbindung steht, wird die Drehbewegung auch auf die Transportrolle 9 übertragen, die sich nun um ihre Längsachse bewegt und damit auch das auf ihr angeordnete Substrat 11 transportiert.

Ein Vorteil der Magnetspaltkupplung 70 liegt darin, dass kein drehbares Dichtelement, wie beispielsweise eine Wellendichtung oder eine Fluiddichtung benötigt wird. Dadurch, dass diese störanfälligen Dichtelemente nicht mehr eingebaut werden müssen, können potentielle Leckstellen in der Vakuumbeschichtungskammer 2 vermieden werden.

Auch sind die Magnetspaltkupplungen kostengünstig herzustellen, verschleißfrei und sehr einfach zu warten. Auf die technisch sehr aufwändigen Drehdurchführungen kann somit verzichtet werden. Die Magnetspaltkupplungen sind drehstabil und zudem vakuumdicht.

Sind die Transportrollen 6 bis 9 über Magnetspaltkupplungen 70 mit einem Antriebssystem 10 verbunden, so kann eine Transportrolle 6 bis 9 durch einfaches Wegnehmen kontaktlos entkoppelt werden.

Über den Abstand der Magnete 45, 46 oder die Feldstärke der Magnete 45, 46 kann auf einfache Art eine Drehmomentbegrenzung eingestellt werden. Ferner können Wellenversätze ohne zusätzliche Bauelemente ausgeglichen werden.

Wie in Fig. 3 zu sehen, befindet sich das Antriebssystem 10 außerhalb der Vakuumbeschichtungskammer 2. Es ist jedoch auch eine Variante denkbar, bei der das Antriebssystem 10 in der Vakuumbeschichtungskammer 2 angeordnet ist. Bei dieser ebenfalls sehr drehstabilen Variante einer einfachen Magnetkupplung ist ein topfförmiger Aufbau 47 nicht mehr notwendig.

Werden die Magnetkupplungen 70 innerhalb der Vakuumbeschichtungskammer 2 angeordnet, können auch die Achsen 40 bis 43 mit den Riemen 34 bis 38 in der Vakuumbeschichtungskammer 2 angeordnet werden. Diese Bauteile bleiben dann immer in der Vakuumbeschichtungskammer 2, damit sie nicht dejustiert werden können. Die Achsen 40 bis 43 mit den Riemen 34 bis 38 werden dann über eine einzige Drehdurchführung oder Magnetkupplung von einem außerhalb der Vakuumbeschichtungskammer 2 befindlichen Motor angetrieben. Es wäre möglich, auch noch den Motor in der Vakuumbeschichtungskammer 2 vorzusehen.

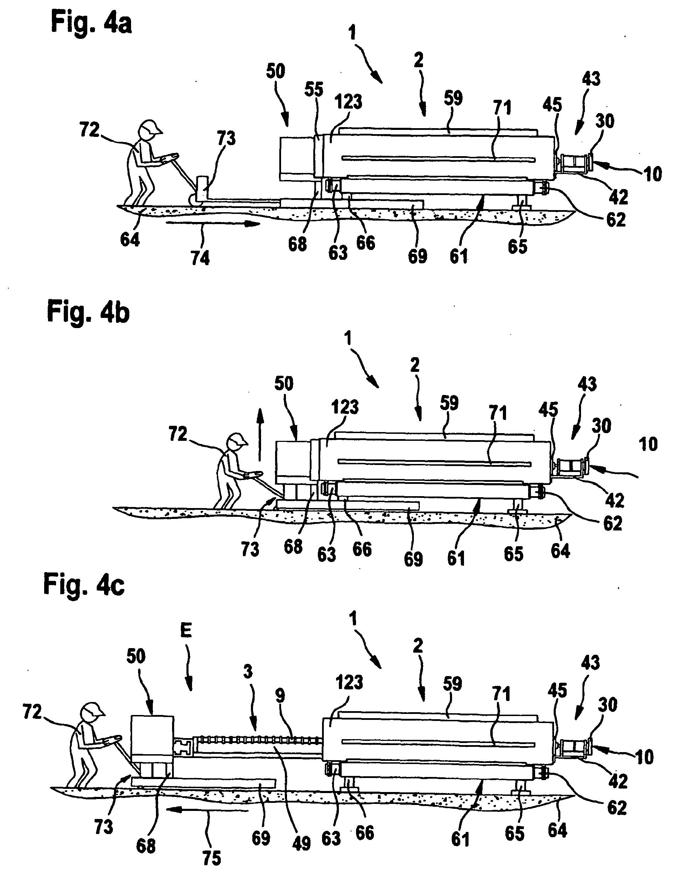

Fig. 4a bis 4c zeigen den Vorgang des Herausnehmens des Einschubelements E aus der in der Fig. 2 dargestellten Vakuumbeschichtungsanlage 1. Die Vakuumbeschichtungskammer 2 mit dem daran angeordneten Pumpensystem 61 weist Sockel 65, 66 auf, die auf dem Boden 64 stehen. Die Vakuumbeschichtungskammer 2 ist außerdem an der Längsseite mit einer schlitzförmigen Öffnung 71 versehen, die in die Wand 21 der Vakuumbeschichtungskammer 2 eingelassen ist. Durch diese Öffnung 71 wird das Substrat 11 in die Vakuumbeschichtungskammer 2 geschleust, ohne dass dies Auswirkungen auf das in der Vakuumbeschichtungskammer 2 herrschende Vakuum hat.

In Fig. 4a bewegt eine Person 72 einen Hubwagen 73 in Richtung des Pfeils 74, d. h. unter die Antriebskammer 50.

In Fig. 4b befindet sich der Hubwagen 73 unter der Vakuumbeschichtungsanlage 2, wodurch das gesamte Einschubelement E leicht angehoben und gemäß Fig. 4c in Richtung des Pfeils 75 aus der Vakuumbeschichtungsanlage 1 entfernt werden kann. Dieses leichte Anheben bewirkt, dass die in der Fig. 2 nicht dargestellte Rolle nahe der Wand 5 über einen Anschlag gehoben wird und so mit dem Herausfahren begonnen werden kann. Das Einschubelement E lastet nun einerseits auf dem Hubwagen 73 und andererseits auf der Rolle 52. So kann das Einschubelement E herausgezogen werden, bis die Rolle 52 an den Anschlag nahe der Wand 5 läuft. Um nun auch diese Rolle 52 über den Anschlag zu heben, wird eine Klappbrücke von ihrer waagrechten Stellung in eine senkrechte Stellung gebracht, in der sie das Ende des Einschubelements E abstützt, an dem die Rolle 52 angebracht ist. Die nicht dargestellte Klappbrücke ist dabei so an den Trägerelementen 69, 69' anzubringen, dass sie in dem fast herausgefahrenen Zustand des Einschubelements E, in dem die Rolle 52 am Anschlag nahe der Wand 5 liegt, im senkrechten Zustand einen Bereich des Einschubelements E abstützt, der sich dann schon außerhalb der Vakuumkammer befindet. Ohne diese stützende Klappbrücke wäre bei ausgebautem Einschubelement E die Last am Gestell 68 wegen des sehr langen freien Kragarms zu hoch.

Nach Entfernen des Einschubelements E kann dieses durch ein anderes ersetzt werden, ohne dass der Beschichtungsprozess für eine lange Zeit unterbrochen werden muss.

Das Einschubelement E kann nun bequem gereinigt bzw. das Target von der Rundrohrkathode 49 entfernt und durch ein neues ersetzt werden.

Das Einschubelement E kann aber auch alternativ auf Rollen, auf einem Luftpolster, auf Schienen oder auf einer ähnlichen Vorrichtung bewegt werden.

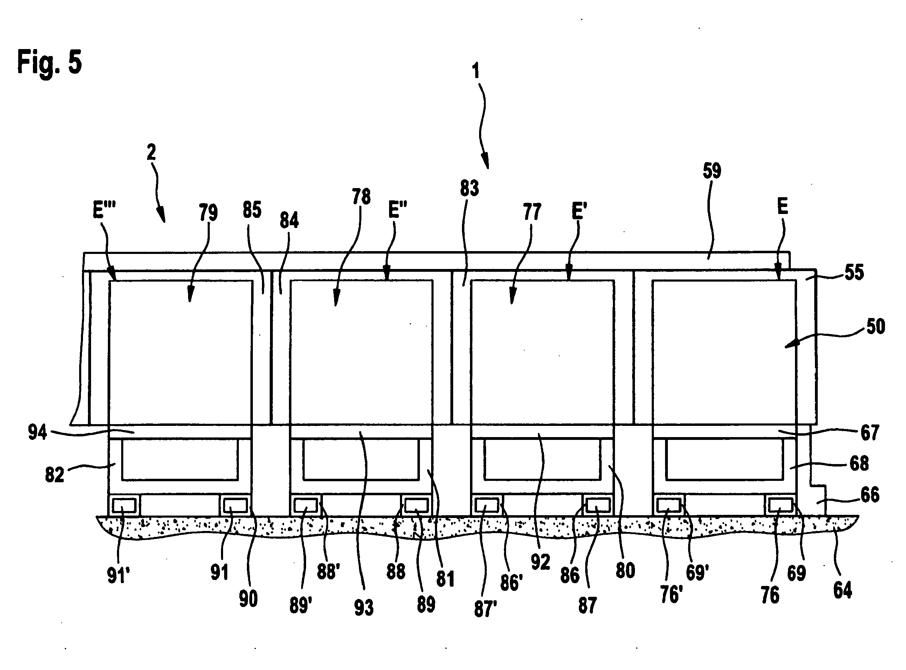

In Fig. 5 ist ein Ausschnitt der in Fig. 4a bis 4c dargestellten Vakuumbeschichtungsanlage 1 nach Drehung um 90° im Uhrzeigersinn gezeigt. Eine Person mit Hubwagen ist der Übersicht halber nicht mit dargestellt.

Zu erkennen sind die neben einander in einem definierten Abstand zueinander angeordneten Antriebskammern 50, 77 bis 79, die jeweils über ein Gestell 67, 68; 80, 92; 81, 93; 82, 94 mit zwei Basiselementen 69, 69'; 86, 86'; 88, 88'; 90, 90' verbunden sind. Diese Basiselemente besitzen jeweils Öffnungen 76, 76'; 87, 87'; 89, 89', 91, 91', in die die Gabeln eines Hubwagens hineingebracht werden können. Jede der Antriebskammern 50, 77 bis 79 verschließt mittels Flanschen 55, 83 bis 85 die Vakuumbeschichtungskammer 2. Die Einschubelemente E bis E"' können einzeln von der Vakuumbeschichtungsanlage 1 entfernt und gewartet werden.

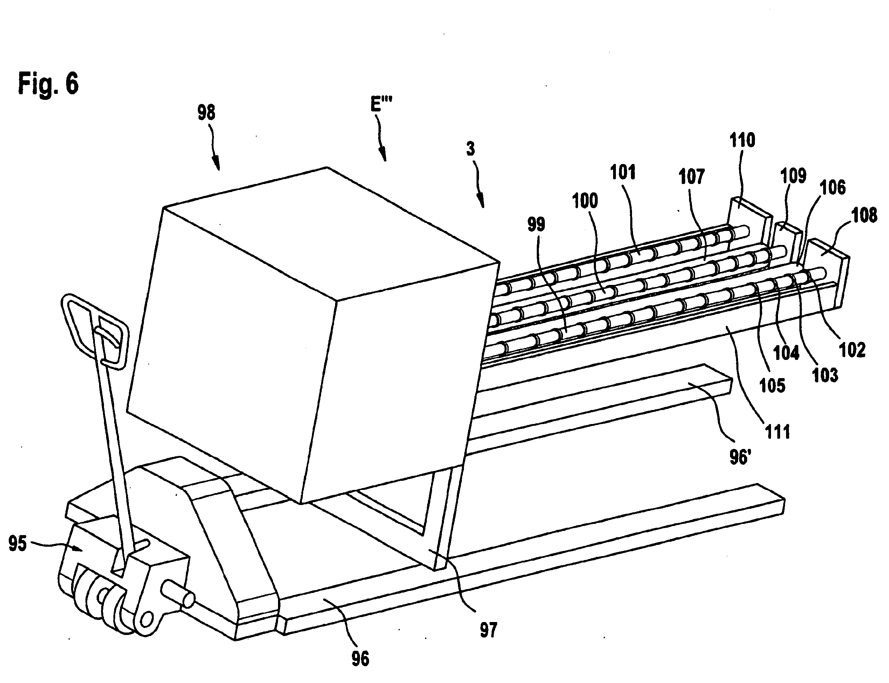

Fig. 6 zeigt eine perspektivische Ansicht eines Einschubelements E"', das mittels eines Hubwagens 95 aus einer Vakuumbeschichtungsanlage herausgezogen worden ist.

Das Einschubelement E"' weist zwei Basiselemente 96, 96' auf, in die die Gabeln des Hubwagens 95 hineingeschoben sind. Auf den Basiselementen 96, 96' ist ein U-förmiges Gestell 97 angebracht, auf dem sich eine Antriebskammer 98 befindet. Die Basiselemente 96, 96' entsprechen funktionsmäßig dem Trägerelement 69 in Fig. 2. Die Gabeln des Hubwagens 95 können zwischen die beiden unteren Basiselemente 96, 96' des Einschubelements E fahren. Sie können aber auch in diese Basiselemente hineinfahren, wenn diese Basiselemente zum Beispiel aus unten offenen U-Profilen bestehen. Wenn das Einschubelement E"' nicht in die Anlage eingebaut ist, schweben die Basiselemente 96, 96' ein wenig über dem Boden.

Das Einschubelement E"' weist mehrere Transportrollen 99 bis 101 auf, die mit Ringen 102 bis 105 versehen sind, die vorzugsweise aus gummielastischem Material bestehen. Unterhalb der Transportrollen 99 bis 101 befinden sich zwei Rundrohrkathoden 106, 107, wobei die Rundrohrkathoden 106, 107 jeweils zwischen zwei benachbarten Transportrollen 99, 100; 100, 101 liegen.

Die Transportrollen 99 bis 101 sind zwischen Sockeln angeordnet, wobei nur die Sockel 108 bis 110 zu sehen sind. Die einander gegenüberliegenden Sockel des Einschubelements E"' sind über Seitenleisten miteinander verbunden, von denen in Fig. 6 lediglich eine Seitenleiste 111 zu erkennen ist.

Wenn ein Einschubelement E ausgebaut wird, wird eine leicht lösbare Verbindung zwischen den kurzen Wellen 40 bis 43 mit den Riemen 35 bis 38 (vgl. Fig. 1) und den eigentlichen Transportrollen 6 bis 9 notwendig. Diese leicht lösbare Verbindung wird bei der Ausführungsform, bei welcher sich alle Antriebsteile in der Vakuumkammer befinden, durch die Magnetkupplungen bewerkstelligt, die sich dann in der Vakuumkammer befinden. Bei dieser Ausführungsform wird die Zahl der topfförmigen Elemente und Membranen reduziert, aber die Anzahl der Bauelemente in der Vakuumkammer nicht erhöht.

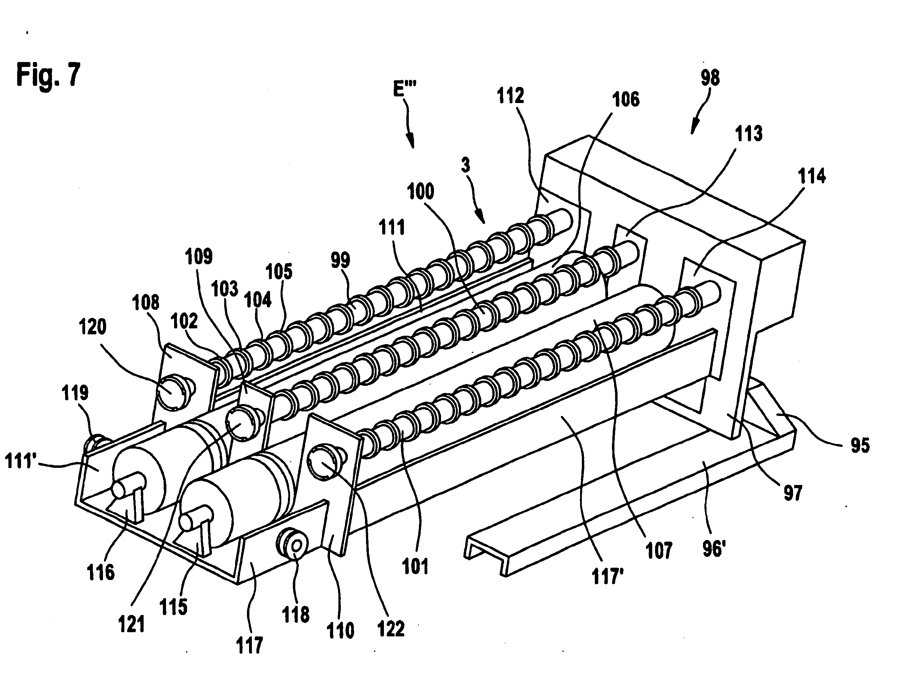

In Fig. 7 ist eine perspektivische Ansicht des in Fig. 6 gezeigten Einschubelements E"' nach einer Drehung um 180° dargestellt. Zu erkennen ist nun, wie die Transportrollen 99 bis 101 zwischen jeweils zwei Sockeln 108, 112; 109, 113; 110, 114 angeordnet sind. An den zum Betrachter zeigenden Enden der Transportrollen 99 bis 101 sind Magnete 120 bis 122 zu sehen. Diese Magnete 120 bis 122 sind jeweils ein Teil einer Magnetkupplung bzw. einer Magnetspaltkupplung einer Vakuumbeschichtungsanlage.

Die Rundrohrkathoden 106, 107 sind jeweils zwischen den Transportrollen 99, 100 bzw. 100, 101 angeordnet und auf Halterungen 115, 116 angebracht; sie stehen mit der Antriebskammer 98 in Verbindung.

Zu erkennen sind auch die Seitenleisten 111, 117, die zwischen den Sockeln 108, 112 bzw. 110, 114 liegen. Diese Seitenleisten 111, 117 verfügen über jeweils ein verlängertes Ende 111', 117', an dem jeweils eine Rolle 118, 119 angebracht ist. Diese Rollen 118, 119 erleichtern den Ausbau bzw. den Wiedereinbau des Einschubelements E'" erheblich, gerade wenn die Vakuumbeschichtungsanlage über Führungen verfügt, wie sie in Fig. 2 dargestellt sind.

Dabei kann die Führung zusätzlich einen Einrastmechanismus aufweisen. Erreicht die Rolle 118, 119 die für sie vorgesehene Führung, so rastet sie ein. Das Einschubelement E"' ist dabei so ausgerichtet, dass seine Magnete 120 bis 122 richtig in der Magnetkupplung bzw. der Magnetspaltkupplung sitzen.

Dadurch, dass Magnetkupplungen verwendet werden, kann das Einschubelement E''' ohne mechanische Demontage aus der Vakuumbeschichtungskammer 2 herausgefahren werden.

## Patentansprüche

1. Vakuumbeschichtungsanlage (1), enthaltend
eine Vakuumbeschichtungskammer (2),
mehrere parallel zueinander angeordnete, drehbare und innerhalb der Vakuumbeschichtungskammer (2) angeordnete Transportrollen (6 - 9, 99 - 101) für den Transport eines flächigen Substrats (11),
**gekennzeichnet durch**:
einen außerhalb der Vakuumbeschichtungskammer (2) angeordneten Antrieb (10, 30 - 33),
wenigstens eine Magnetkupplung (45, 46, 70) zwischen dem Antrieb und wenigstens einer Transportrolle (6).

2. Vakuumbeschichtungsanlage (1), enthaltend
eine Vakuumbeschichtungskammer (2)
mehrere parallel zueinander angeordnete, drehbare und innerhalb der Vakuumbeschichtungskammer (2) angeordnete Transportrollen (6 - 9, 99 - 101) für den Transport eines flächigen Substrats (11),
**gekennzeichnet durch**:
einen innerhalb der Vakuumbeschichtungskammer (2) angeordneten Antrieb, wenigstens eine Magnetkupplung (45, 46, 70) zwischen dem Antrieb und wenigstens einer Transportrolle (6).

3. Vakuumbeschichtungsanlage (1) nach den Ansprüchen 1 oder 2, **dadurch gekennzeichnet, dass** die wenigstens eine Transportrolle (6) über Riemen (34 - 38) mit den anderen Transportrollen (7 - 9) gekoppelt ist.

4. Vakuumbeschichtungsanlage (1) nach den Ansprüchen 1 oder 2, **dadurch gekennzeichnet, dass** jede Transportrolle (6 - 9) über eine eigene Magnetkupplung (45, 46, 70) mit einem eigenen Antrieb gekoppelt ist.

5. Vakuumbeschichtungsanlage (1) nach Anspruch 1, **dadurch gekennzeichnet, dass** in eine Wand (4) der Vakuumbeschichtungskammer (2) ein topfförmiger Aufbau (47) aus nicht magnetischem und nicht magnetisierbarem Material eingelassen ist, der wenigstens einen in der Vakuumbeschichtungskammer (2) befindlichen Magneten (46) von wenigstens einem außerhalb der Vakuumbeschichtungskammer (2) befindlichen Magneten (47) trennt.

6. Vakuumbeschichtungsanlage (1) nach den Ansprüchen 1 oder 2, **dadurch gekennzeichnet, dass** die Transportrollen (6 - 9, 99 - 101) zumindest teilweise von gummielastischem Material (12 - 20, 102 -105) umgeben sind.

7. Vakuumbeschichtungsanlage (1) nach den Ansprüchen 1 oder 2, **dadurch gekennzeichnet, dass** zwischen den Transportrollen (6 - 9, 99 - 101) Sputterelektroden (49) angeordnet sind.

8. Vakuumbeschichtungsanlage (1) nach Anspruch 2, **dadurch gekennzeichnet, dass** die Transportrollen (6 - 9, 99 - 101) und die wenigstens eine Magnetkupplung (45, 46, 70) Teil eines Einschubelements (E - E"') sind, das aus der Vakuumbeschichtungskammer (2) heraus- und in diese hineinfahrbar ist.

9. Vakuumbeschichtungsanlage (1) nach Anspruch 1, **dadurch gekennzeichnet, dass** die Transportrollen (6 - 9, 99 - 101) Teil eines Einschubelements (E - E"') sind, das aus der Vakuumbeschichtungskammer (2) heraus- und in diese hineinfahrbar ist, wobei der Antrieb (10) für die Transportrollen (6 - 9, 99 - 101) außerhalb der Vakuumbeschichtungskammer (2) verbleibt.

10. Vakuumbeschichtungsanlage (1) nach den Ansprüchen 7, 8 und 9, **dadurch gekennzeichnet, dass** die Sputterelektroden (49) Teil des Einschubelements (E - E"') sind.

11. Vakuumbeschichtungsanlage (1) nach den Ansprüchen 1 oder 2, **dadurch gekennzeichnet, dass** die Transportrollen (6 - 9, 99 -101) über Achsen (40 - 43) mit den Magnetkupplungen (30 - 33) verbunden sind, die eine Verbindung zum Antrieb herstellen.

12. Vakuumbeschichtungsanlage (1) nach Anspruch 11, **dadurch gekennzeichnet, dass** zwischen den Achsen (40 - 43) und den Transportrollen (6 - 9, 99 - 101) Magnetkupplungen vorgesehen sind.

13. Vakuumbeschichtungsanlage (1) nach Anspruch 8 oder Anspruch 9, **dadurch gekennzeichnet, dass** das Einschubelement (E - E"') ein Gestell (68, 69) aufweist, das mittels eines Hubwagens (73) anhebbar ist.

14. Vakuumbeschichtungsanlage (1) nach Anspruch 8 oder Anspruch 9, **dadurch gekennzeichnet, dass** eine Kammer (50), die einen Antrieb für Sputterkathoden (49) enthält, Teil des Einschubelements (E - E"') ist.

## Claims

1. Vacuum coating installation (1) comprising
a vacuum coating chamber (2),
several rotatable transport rollers (6 - 9, 99 - 101) disposed in parallel within the vacuum coating chamber (2) for the transport of a planar substrate (11),
**characterized by**:
a driving means (10, 30 - 33) disposed outside of the vacuum coating installation (2),
at least one magnet coupling (45, 46, 70) between the driving means and at least one transport roller (6).

2. Vacuum coating installation (1) comprising
a vacuum coating chamber (2)
several rotatable transport rollers (6 - 9, 99 - 101) disposed in parallel and within the vacuum coating chamber (2) for the transport of a planar substrate (11),
**characterized by**:
a driving means disposed within the vacuum coating chamber (2),
at least one magnet coupling (45, 46, 70) between the driving means and at least one transport roller (6).

3. Vacuum coating installation (1) as claimed in claims 1 or 2, **characterized in that** the at least one transport roller (6) is coupled with the other transport rollers (7 - 9) via belts (34 - 38).

4. Vacuum coating installation (1) as claimed in claims 1 or 2, **characterized in that** each transport roller (6 - 9) is coupled with its own driving means via its own magnet coupling (45, 46, 70).

5. Vacuum coating installation (1) as claimed in claim 1, **characterized in that** in one wall (4) of the vacuum coating installation (2) a cup-form top structure (47) is embedded comprised of a non-magnetic and non-magnetizable material, which separates at least one magnet (46) located in the vacuum coating chamber (2) from at least one magnet (47) located outside of the vacuum coating chamber (2).

6. Vacuum coating installation (1) as claimed in one of claims 1 or 2, **characterized in that** the transport rollers (6 - 9, 99 - 101) are at least partially encompassed by rubber-type elastic material (12 - 20, 102 - 105).

7. Vacuum coating installation (1) as claimed in claims 1 or 2, **characterized in that** between the transport rollers (6 - 9, 99 - 101) sputter electrodes (49) are disposed.

8. Vacuum coating installation (1) as claimed in claim 2, **characterized in that** the transport rollers (6 - 9, 99 - 101) and the at least one magnet coupling (45, 46, 70) are part of a slide-in element (E - E"') which can be moved into and out of the vacuum coating chamber (2).

9. Vacuum coating installation (1) as claimed in claim 1, **characterized in that** the transport rollers (6 - 9, 99 - 101) are part of a slide-in element (E - E"') which can be moved into and out of the vacuum coating chamber (2), the driving means (10) for the transport rollers (6 - 9, 99 - 101) remaining outside of the vacuum coating chamber (2).

10. Vacuum coating installation (1) as claimed in claims 7, 8 and 9, **characterized in that** the sputter electrodes (49) are part of the slide-in element (E - E"').

11. Vacuum coating installation (1) as claimed in claims 1 or 2, **characterized in that** the transport rollers (6 - 9, 99 - 101) are connected via axles (40 - 43) with the magnet couplings (30 - 33) which establish a connection to the driving means.

12. Vacuum coating installation (1) as claimed in claim 11, **characterized in that** between the axles (40 - 43) and the transport rollers (6 - 9, 99 - 101) magnet couplings are provided.

13. Vacuum coating installation (1) as claimed in claim 8 or claim 9, **characterized in that** the slide-in element (E - E"') includes a frame (68, 69) which can be lifted by means of a fork-lift carriage (73).

14. Vacuum coating installation (1) as claimed in claim 8 or claim 9, **characterized in that** a chamber (50) including a driving means for sputter cathodes (49) is part of the slide-in element (E - E"').

## Revendications

1. Appareillage de revêtement sous vide (1) comprenant
une chambre de revêtement sous vide (2),
plusieurs roulettes de transport (6 - 9, 99 - 101) pour le transport d'un substrat plan (11) disposées parallèlement les unes aux autres, rotatives, et disposées à l'intérieur de la chambre de revêtement sous vide (2),
**caractérisé par**
un mécanisme d'entraînement (10, 30 - 33) disposé à l'extérieur de l'appareillage de revêtement sous vide (2),
au moins un accouplement à aimant (45, 46, 70) entre le mécanisme d'entraînement et au moins une roulette de transport (6).

2. Appareillage de revêtement sous vide (1) comprenant
une chambre de revêtement sous vide (2),
plusieurs roulettes de transport (6 - 9, 99 - 101) pour le transport d'un substrat plan (11) disposées parallèlement les unes aux autres, rotatives, et disposées à l'intérieur de la chambre de revêtement sous vide (2),
**caractérisé par**
un mécanisme d'entraînement disposé à l'intérieur de la chambre de revêtement sous vide (2),
au moins un accouplement à aimant (45, 46, 70) entre le mécanisme d'entraînement et au moins une roulette de transport (6).

3. Appareillage de revêtement sous vide (1) selon la revendication 1 ou 2, **caractérisé en de que** la roulette de transport (6) - il en existe au moins une - est couplée par le biais de courroies (34 - 38) aux autres roulettes de transport (7 - 9).

4. Appareillage de revêtement sous vide (1) selon la revendication 1 ou 2, **caractérisé en de que** chaque roulette de transport (6 - 9) est couplée par le biais de son propre accouplement à aimant (45, 46, 70) à un mécanisme d'entraînement qui lui est propre.

5. Appareillage de revêtement sous vide (1) selon la revendication 1, **caractérisé en ce que** dans une paroi (4) de l'appareillage de revêtement sous vide (2) est encastrée une structure (47) en forme de pot réalisée en une matière non magnétique et non aimantable, laquelle sépare au moins un aimant (46) situé dans la chambre de revêtement sous vide (2) d'au moins un aimant (47) situé à l'extérieur de la chambre de revêtement sous vide (2).

6. Appareillage de revêtement sous vide (1) selon la revendication 1 ou 2, **caractérisé en ce que** les roulettes de transport (6 - 9, 99 - 101) sont entourées au moins partiellement de matière élastique caoutchoutée (12 - 20, 102 - 105).

7. Appareillage de revêtement sous vide (1) selon la revendication 1 ou 2, **caractérisé en ce que** des électrodes de pulvérisation cathodique (49) sont disposées entre les roulettes de transport (6 - 9, 99 - 101).

8. Appareillage de revêtement sous vide (1) selon la revendication 2, **caractérisé en ce que** les roulettes de transport (6 - 9, 99 - 101) et l'accouplement à aimant (45, 46, 70) - il en existe au moins un - font partie d'un élément insérable (E - E"') qui peut sortir de la chambre de revêtement sous vide (2) et y entrer.

9. Appareillage de revêtement sous vide (1) selon la revendication 1, **caractérisé en ce que** les roulettes de transport (6 - 9, 99 - 101) font partie d'un élément insérable (E - E"') qui peut sortir de la chambre de revêtement sous vide (2) et y entrer, le mécanisme d'entraînement (10) pour les roulettes de transport (6 - 9, 99 - 101) restant à l'extérieur de la chambre de revêtement sous vide (2).

10. Appareillage de revêtement sous vide (1) selon les revendications 7, 8 et 9, **caractérisé en ce que** les électrodes de pulvérisation cathodique (49) font partie de l'élément insérable (E- E"').

11. Appareillage de revêtement sous vide (1) selon la revendication 1 ou 2, **caractérisé en ce que** les roulettes de transport (6 - 9, 99 - 101) sont reliées par le biais d'axes (40 - 43) aux accouplements à aimant (30 - 33), lesquels établissent une liaison avec le mécanisme d'entraînement.

12. Appareillage de revêtement sous vide (1) selon la revendication 11, **caractérisé en ce que** des accouplements à aimant sont prévus entre les axes (40 - 43) et les roulettes de transport (6 - 9, 99 - 101).

13. Appareillage de revêtement sous vide (1) selon la revendication 8 ou la revendication 9, **caractérisé en ce que** l'élément insérable (E - E"') présente un bâti (68, 69) qui peut être soulevé au moyen d'un chariot élévateur (73).

14. Appareillage de revêtement sous vide (1) selon la revendication 8 ou la revendication 9, **caractérisé en ce qu'**une chambre (50) qui contient un mécanisme d'entraînement pour des cathodes de pulvérisation (49) fait partie de l'élément insérable (E - E"').
